# EUROPÄISCHE PATENTSCHRIFT

(11) **EP 1 196 017 B1**
(45) Veröffentlichungstag und Bekanntmachung des Hinweises auf die Patenterteilung: **07.05.2008**
(21) Anmeldenummer: 01105764.3
(22) Anmeldetag: 08.03.2001
(51) Int. Cl.: H05K 9/00, H05K 1/02

(54) **Filteranordnung**
Filtering device
Dispositif de filtrage

(30) Priorität: 21.03.2000 DE 10013936
(43) Veröffentlichungstag der Anmeldung: 10.04.2002
(73) Patentinhaber: Diehl Aerospace GmbH, 88662 Überlingen (DE)
(72) Erfinder: Michling, Hans-Joachim, 88662 Überlingen (DE); Gerstenberg, Bruno, 88696 Owingen (DE); Messmer, Helmut, 78269 Volkertshausen (DE)
(74) Vertreter: Diehl Patentabteilung

(56) Entgegenhaltungen:
- EP-A- 0 688 158
- DE-A1- 3 823 469
- DE-A1- 19 630 720
- FR-A- 2 497 410
- US-A- 4 480 240
- US-A- 5 165 055
- PATENT ABSTRACTS OF JAPAN Bd. 1998, Nr. 14, 31. Dezember 1998 (1998-12-31) & JP 10 233562 A (CANON INC), 2. September 1998 (1998-09-02)
- PATENT ABSTRACTS OF JAPAN Bd. 011, Nr. 171 (E-512), 2. Juni 1987 (1987-06-02) & JP 62 005712 A (MATSUSHITA ELECTRIC IND CO LTD), 12. Januar 1987 (1987-01-12)

## Beschreibung

### Technisches Gebiet

Die Erfindung betrifft eine Leiterkarte nach dem Oberbegriff des Anspruchs 1.

### Zugrundeliegender Stand der Technik

Bei vielen elektronischen Geräten müssen elektronische Komponenten gegen elektromagnetische Einwirkungen geschützt werden. Dies erfolgt u.a. durch Filteranordnungen.

Durch die DE 38 23 469 A1 ist eine Filteranordnung zur Filterung einer Mehrzahl von Leitungen bekannt, welche in einem Gehäuse aus einem elektromagnetische Felder enthaltenden Raum durch eine Trennwand zu einem in einem abgeschirmten Raum befindlichen Gerät geführt sind. Die Trennwand ist von einer mehrlagigen Leiterkarte gebildet. Die Leiterkarte enthält eine durchgehende interne Massefläche, welche mit dem Gehäuse elektrisch verbunden ist und Durchbrüche als Signaldurchführungsmittel aufweist, durch welche Durchsteiger hindurchgeführt sind. Auf der Leiterkarte sind Filterbauteile montiert. Die Durchsteiger bilden mit der Massefläche einen Kondensator, über welche hochfrequente Signale zur Masse abgeleitet werden. Der Durchbruch ist sehr eng, so daß dort hindurch keine Störfelder in den abgeschirmten Raum gelangen.

Durch die DE 196 30 720 A1 ist eine Filteranordnung zur Trennung eines HF-Felder enthaltenden Bereiches von einem gegen HF-Felder abgeschirmten Bereich bekannt. Die Filteranordnung ist in einer in einem Metallgehäuse angeordneten mehrlagigen Leiterkarte längs einer Trennfläche vorgesehen. Die Trennfläche verläuft quer zur Ebene der Lagen der Leiterkarte. Längs der Trennfläche sind in Lagen, welche jeweils durch eine dazwischenliegende Lage von einander getrennt sind, metallisierte Masseflächen gebildet. In den dazwischenliegenden Lagen sind Leiterbahnen durch die Trennfläche hindurchgeführt. In diesen Leiterbahnen sind im Bereich der Trennfläche leitende Flächen gebildet, welche mit den Masseflächen Filterkondensatoren zur Ableitung von HF-Feldern bilden. Im Bereich der Trennfläche ist das Gehäuse durch eine Trennwand in zwei Räumen unterteilt. Die EP 0 688 158 A1 zeigt eine ähnliche Filteranordnung.

### Offenbarung der Erfindung

Der Erfindung liegt die Aufgabe zugrunde, eine sehr einfache Filteranordnung der eingangs genannten Art auszubilden.

Der Erfindung liegt weiterhin die Aufgabe zugrunde, eine Filteranordnung der eingangs genannten Art so auszubilden, daß eine wirksame HF-Filterung von Signalleitungen auch in hohen Frequenzbereichen erhalten wird.

Erfindungsgemäß wird diese Aufgabe durch die im kennzeichnenden Teil des Anspruchs 1 angegebenen Merkmale gelöst.

Der Erfindung liegt die Idee zugrunde, den Skineffekt zur Trennung von HF-Energie (HF = Hochfrequenz) und niederfrequenter Signalenergie zu nutzen. Der Skineffekt besagt, daß sich der Strom bei hoher Frequenz nicht über den ganzen Querschnitt eines Leiters mit gleicher Dichte verteilt, sondern sich an die Oberfläche drängt. Die Veranlassung dazu ist die innere Selbstinduktion. Bei hohen Frequenzen fließen also HF-Ströme nur noch in einer dünnen Oberflächenschicht und zwar in der Art, daß die Fläche des entsprechenden Stromkreises minimiert wird. So steigt z.B. die Transimpedanz von massiven Leitungsschirmen (Rohren) mit steigender Frequenz an, weil durch den Skineffekt der HF-Störstrom zunehmend auf der Außenseite des Schirms fließt und Signalstrom und HF-Strom dadurch zunehmend entkoppelt werden.

In der zu filternden Signalleitung findet ebenfalls eine solche auf dem Skineffekt beruhende Entkopplung von Signalstrom und HF-Strom statt. Bei konstruktiv günstiger Auslegung der Signalleitung, nämlich beispielsweise als Leiterbahn in der Nähe einer Massefläche, wird sich die HF-Energie auf der der Massefläche zugewandten Seite der Signalleitung konzentrieren. Die der Massefläche abgewandte Seite der Signalleitung ist dann weitgehend von HF-Energie entkoppelt, so daß hier eine weitgehend von HF-Energie ungestörte Weiterführung des eigentlichen Signalweges erfolgen kann. Im Filterbereich wird die Signalleitung bzw. Leiterbahn so unterbrochen bzw. aufgetrennt, daß nur eine geringe Überkopplung von HF-Energie in den davor zu schützenden Verarbeitungsbereich möglich ist. Es erfolgt dann eine Reflexion der HF-Energie. Der direkte Signalfluß auf der gleichen Lage ist natürlich damit unterbrochen. Der Signalfluß wird dann auf einer anderen Lage weitergeführt, welche sich auf der der Massefläche abgewandten Seite der Signalleitung befindet, d.h. die zu filternde Signalleitung befindet sich in einer Lage zwischen der die Massefläche enthaltenden Lage und der die Signalweiterleitung enthaltenden Lage. Das Weiterführen des Signalflusses auf einer anderen Lage erfolgt über eine oder mehrere Durchkontaktierungen.

Vorzugsweise ist die zweite und/oder die dritte Lage eine zu der ersten Lage benachbarte Lage, d.h. die Massefläche befindet sich möglichst nahe an der zu filternden Signalleitung und/oder die Weiterführung des Signalflusses erfolgt ebenfalls in einer benachbarten Lage. Zur besseren Entkopplung kann es jedoch auch vorteilhaft sein, den Signalfluß in einer Lage weiterzuführen, welche von der zu filternden Signalleitung weiter entfernt ist.

Hinter dem Filterbereich kann der Signalfluß wieder in der ersten Lage weitergeführt werden. Dies erfolgt wiederum über eine oder mehrere Durchkontaktierungen. Die zu filternde Signalleitung ist dann in drei Abschnitte aufgeteilt, nämlich zwei in der ersten Lage voneinander getrennten Abschnitte sowie einen dritten Abschnitt in der dritten Lage.

Zum Verbessern der Filterwirkung kann die zu filternde Signalleitung eine oder mehrere Kondensatorflächen in dem Filterbereich aufweisen. Diese Kondensatorflächen können von Verbreiterungen der Signalleitung bzw. der Leiterbahn gebildet sein.

Für den Fall, daß der Schutz des vor HF-Energie zu schützenden Verarbeitungsbereiches allein durch die beschriebene Anordnung unter Verwendung des Skineffektes nicht ausreicht, kann eine Kombination von L- und/oder C-Filterung zusammen mit der beschriebenen Anordnung zur Anwendung kommen. Solche L- und C-Filterung sind an sich bekannt und werden hier nicht näher beschrieben.

In dem dritten Abschnitt der Signalleitung können Induktivitäten beispielsweise in Form von diskreten Induktivitäten oder integrierten Spulen (d.h. Induktivität, welche durch entsprechende Verlegung von Leiterbahnen erzeugt wird) realisiert sein, wobei (in Signalfluß gesehen) davor oder danach Kapazitäten angeordnet werden können. Die integrierte Induktivität wird vorzugsweise nahe der Oberfläche angeordnet, so daß ihre Wirkung möglichst groß ist. Anstelle von Induktivitäten können auch ohmsche Widerstände in irgendeiner Form verwendet werden.

Die Leiterkarte wird üblicherweise in einem Gehäuse mit Steckern angeordnet. Die oben beschriebenen Maßnahmen sind dann sehr wirksam, wenn die HF-Energie sich hauptsächlich oder ausschließlich in der Signalleitung ausbreitet bzw. in den Zuleitungen vom Stecker des Gehäuses zu den Leiterbahnen. Ist jedoch damit zu rechnen, daß eine Ausbreitung auch durch Strahlung innerhalb des Gehäuses erfolgt, so kann der die Strahlung enthaltende Teil ("schmutziger" Raum) von dem davor zu schützenden Teil ("sauberer" Raum) mittels einer HF-Schirmwand getrennt werden, welche sowohl im Filterbereich, vor dem Filterbereich als auch hinter dem Filterbereich angeordnet sein kann.

Mit der beschriebenen, auf dem Skineffekt beruhenden Anordnung ist es möglich, eine wirksame HF-Filterung von Signalleitungen auch in hohen Frequenzbereichen über 100 MHz bis in den GHz-Bereich hinein zu erreichen, da der Skineffekt mit zunehmender Frequenz gleichfalls immer wirksamer wird und der positive Effekt der Anordnung erhalten bleibt.

Natürlich ist es möglich, nicht nur eine Signalleitung, sondern auch mehrere, beispielsweise als Leiterbahnen ausgebildete Signalleitungen in verschiedenen oder in einer und derselben Lage in der oben beschriebenen Art zu filtern.

Ausführungsbeispiele der Erfindung sind nachstehend unter Bezugnahme auf die zugehörigen Zeichnungen näher erläutert.

### Kurze Beschreibung der Zeichnungen

- Fig. 1: ist eine schematische, teilweise gebrochene Darstellung und zeigt in Draufsicht ein erstes Ausführungsbeispiel einer in einer Leiterkarte integrierten Filteranordnung zur Trennung von HF-Energie und Signalenergie.
- Fig. 2: ist eine schematische, teilweise gebrochene Schnittdarstellung und zeigt die Filteranordnung von Fig. 1 in Seitenansicht.
- Fig. 3: zeigt das Ersatzschaltbild für die in Fig. 1 und 2 dargestellte Filteranordnung.
- Fig. 4: ist eine schematische, teilweise gebrochene Schnittdarstellung und zeigt in Draufsicht ein zweites Ausführungsbeispiel einer in einer Leiterkarte integrierten Filteranordnung zur Trennung von HF-Energie und Signalenergie.
- Fig. 5: zeigt das Ersatzschaltbild für die in Fig. 4 dargestellte Filteranordnung.

### Bevorzugte Ausführung der Erfindung

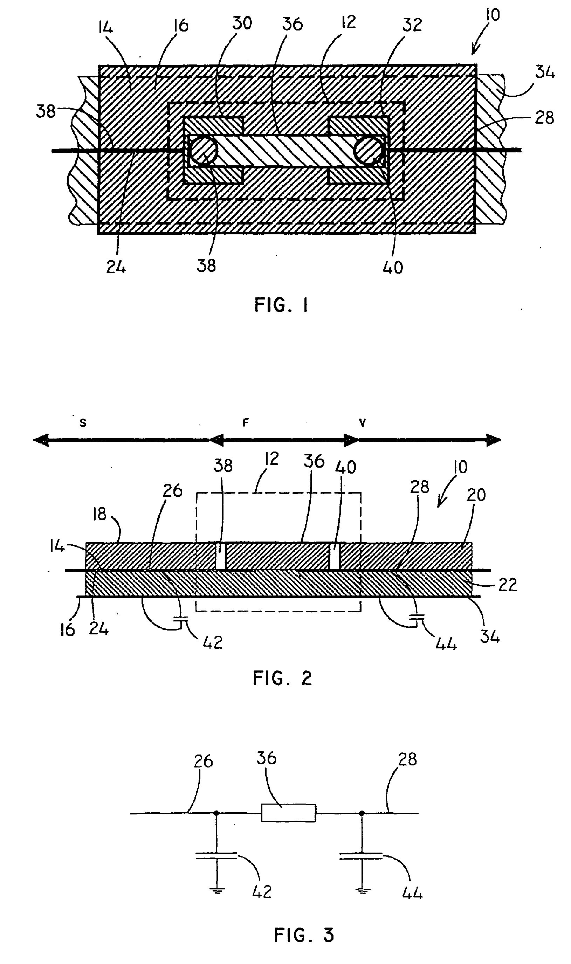

Fig. 1 und 2 zeigen ein erstes Ausführungsbeispiel einer Filteranordnung. Mit 10 ist eine Leiterkarte bezeichnet. Die Leiterkarte 10 kann in einem (nicht gezeigten) Gehäuse untergebracht sein. Die Leiterkarte 10 (und gegebenenfalls das Gehäuse) ist durch eine in der Leiterkarte 10 integrierte, in Fig. 1 und 2 mit gestrichelten Linien angedeutete Filteranordnung 12 (Filterbereich) in zwei getrennte Bereichen unterteilt. Der in Fig. 1 und 2 links von der Filteranordnung 12 liegende Bereich ("schmutziger" Bereich bzw. Steckerbereichs) der Leiterkarte 10 enthält HF-Energie, der rechts von der Filteranordnung 12 liegende Bereich ("sauberer" Bereich bzw. Verarbeitungsbereich V) wird durch die Filteranordnung 12 im Filterbereich F vor HF-Energie geschützt.

Die in Fig. 1 und 2 dargestellte Leiterkarte 10 weist drei benachbarte Lagen 14, 16 und 18 auf, welche alle in Fig. 2 sichtbar sind. In Fig. 1 sind lediglich die erste und die zweite Lage 14 und 16 sichtbar, wobei die zweite Lage 16 zum Sichtbarmachen der ersten Lage 14 transparent gezeichnet ist. Die Lagen 14, 16 und 18 sind durch Isolatorschichten 20 und 22 elektrisch von einander isoliert.

Der Signalfluß in einer zu filternden Signalleitung 24 verläuft in der Leiterkarte 10 von links nach rechts in den Fig. 1 und 2. Die Signalleitung 24 verläuft in der ersten Lage 14 als eine Leiterbahn, welche in der Lage 14 nicht durchgehend, sondern unterbrochen ist, so daß zwei in der Lage 14 elektrisch voneinander getrennte Abschnitte 26 und 28 der Leiterbahn entstehen. Der in dem "schmutzigen" Bereich verlaufende Abschnitt 26 stellt die Signaleingangsleitung, der in dem "sauberen" Bereich verlaufende Abschnitt 28 die Signalausgangsleitung der Filteranordnung 12 dar. In dem Filterbereich 12 weisen die Abschnitte 26 und 28 der Leiterbahn jeweils eine Kondensatorfläche 30 bzw. 32 auf. In dem dargestellten Ausführungsbeispiel werden die Kondensatorflächen 30 und 32 von Verbreiterungen der Abschnitte 26 und 28 der Leiterbahn in dem Filterbereich gebildet.

In der in den Fig. 1 und 2 unterhalb der ersten Lage 14 angeordneten zweiten Lage 16 befindet sich eine Massefläche 34. In dem dargestellten Ausführungsbeispiel ist die Massefläche 34 eine ganz oder partiell durchgehende Fläche. Zwischen der Massefläche 34 und den Kondensatorflächen 30 bzw. 32 wird damit jeweils ein Plattenkondensator 42 bzw. 44gebildet.

In der in den Fig. 1 und 2 oberhalb der ersten Lage 14 angeordneten dritten Lage 18 befindet sich ein dritter Abschnitt 36 der Signalleitung 24. Dieser Abschnitt 36 ist in dem in Fig. 1 und 2 dargestellten Ausführungsbeispiel als kurze Leiterbahn ausgebildet, kann jedoch auch Induktivitäten oder ohmsche Widerstände aufweisen. Der dritte Abschnitt 36 der Signalleitung 24 ist mit dem ersten und mit dem zweiten Abschnitt 26 bzw. 28 elektrisch verbunden. Dies erfolgt in bekannter Weise über Durchkontaktierungen in Form von Durchsteigern 38 und 40, welche sich durch die Isolatorschicht 20 erstrecken. Diese Durchsteiger können beispielsweise in Sacklochtechnik oder als normale Durchkontaktierungen ausgebildet sein, oder auch nur den Anschlußpad eines Bauteiles darstellen.

Zum schaltungsmässigen Verständnis des Herausfilterns von HF-Energie bei einem Signalverlauf von dem Abschnitt 26 zu dem Abschnitt 28 der Signalleitung ist in Fig. 3 das Ersatzschaltbild für die in Fig. 1 und 2 dargestellte Filteranordnung dargestellt. Die Schaltung enthält die beiden Abschnitte 26 und 28 der Signalleitung sowie den dritten Abschnitt 36 als Induktivität. Die beiden Plattenkondensatoren 42 und 44 stellen die Kondensatorwirkung zwischen den Kondensatorflächen 30 und 32 und der Massefläche 34 dar. Aus der Schaltung ist erkennbar, daß HF-Energie bei einem Signalverlauf von dem Abschnitt 26 zu dem Abschnitt 28 herausgefiltert wird. Wie aus Fig. 2 und 3 ersichtlich, wirkt die dargestellte Filteranordnung symmetrisch, so daß Eingang und Ausgang der Filteranordnung vertauscht werden können.

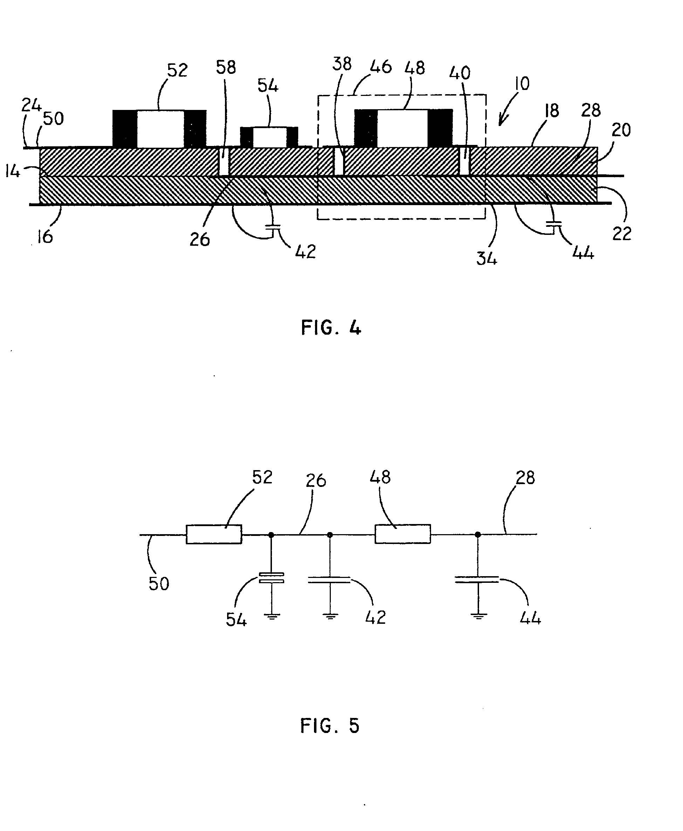

Fig. 4 zeigt ein zweites Ausführungsbeispiel einer Filteranordnung und Fig. 5 zeigt das entsprechende Ersatzschaltbild. Die Filteranordnung von Fig. 4 unterscheidet sich von der Filteranordnung von Fig. 1 und 2 hauptsächlich dadurch, daß sie zusätzliche diskrete Komponenten aufweist. Entsprechende Teile sind in Fig. 4 und 5 mit den gleichen Bezugszeichen versehen sind wie in Fig. 1-3.

Der in Fig. 4 mit gestrichelten Linien angedeutete rechte Teil 46 der Filteranordnung stimmt nahezu vollständig mit der in Fig. 1 und 2 dargestellten Filteranordnung 12 überein und wird deswegen hier nicht nochmals beschrieben. Bzgl. der Filteranordnung 12 von Fig. 1 und 2 ist in diesem Teil 46 der Filteranordnung lediglich die kurze Leiterbahn 36 (s. Fig. 1 und 2) durch eine erste diskrete Induktivität 48 ersetzt.

Wie bei dem ersten Ausführungsbeispiel enthält der in Fig. 4 links von der Filteranordnung liegende Bereich ("schmutziger" Bereich bzw. Steckerbereich) der Leiterkarte 10 HF-Energie und der rechts von der Filteranordnung liegende Bereich ("sauberer" Bereich bzw. Verarbeitungsbereich) wird durch die Filteranordnung vor HF-Energie geschützt.

Der Signalfluß in der zu filternden Signalleitung 24 verläuft in der Leiterkarte 10 von links nach rechts in Fig. 4. Die Signalleitung 24 verläuft zunächst in der dritten Lage 18 als eine Leiterbahn 50. In dieser Leiterbahn 50 ist eine zweite diskrete Induktivität 52 und eine Kapazität 54 integriert. Der links von der zweiten Induktivität 52 liegende Abschnitt der Leiterbahn 50 stellt die Signaleingangsleitung der Filteranordnung dar. Hinter der Kapazität 54 liegt die Leiterbahn 50 an Masse. Zwischen der zweiten Induktivität 52 und der Kapazität 54 setzt sich die Signalleitung in einem in der ersten Lage 14 verlaufenden Abschnitt 26 fort. Dieser Abschnitt 26 entspricht dem in dem ersten Ausfühungsbeispiel erwähnten Abschnitt 26, wobei der Abschnitt 26 in Fig. 4 jedoch nicht wie in Fig. 2 und 3 die Signaleingangsleitung der Filteranordnung darstellt. Die in der dritten Lage 18 verlaufende Leiterbahn 50 ist zwischen der zweiten Induktivität 52 und der Kapazität 54 mit dem Abschnitt 26 der Signalleitung 24 elektrisch verbunden. Dies erfolgt in bekannter Weise über eine Durchkontaktierung in Form eines Durchsteigers 58, welche sich durch die Isolatorschicht 20 erstreckt. Der weitere Verlauf der Signalleitung 24 zu dem in dem "sauberen" Bereich verlaufenden Abschnitt 28 als Signalausgangsleitung der Filteranordnung ist im Zusammenhang mit Fig. 1 und 2 beschrieben.

Die in den Figuren dargestellte Leiterkarte 10 hat drei Lagen. Die Leiterkarte 10 kann jedoch mehr als drei Lagen haben. Dabei können die gezeigten Signalleitungen, die Massefläche und die sonstigen Filterkomponenten in drei benachbarten oder nicht benachbarten Lagen angeordnet sein. Selbstverständlich ist es auch möglich, mehr als eine Signalleitung in der Leiterkarte 10 in der beschriebenen Weise zu filtern.

Wenn die Leiterkarte in einem Gehäuse untergebracht ist, kann das Gehäuse zur Vermeidung von Ausbreitung der HF-Energie durch Strahlung durch eine HF-Schirmwand in einen die Strahlung enthaltenden Teil ("schmutziger" Raum) und einen davor zu schützenden Teil ("sauberer" Raum) getrennt sein. Dieser HF-Schirmwand kann sowohl im Filterbereich, vor dem Filterbereich als auch hinter dem Filterbereich angeordnet sein.

## Patentansprüche

1. Mehrlagige Leiterkarte (10) mit einer Filteranordnung zur Trennung von HF-Energie und Signalenergie in einer wenigstens teilweise in einer ersten Lage (14) der mehrlagigen Leiterkarte (10) verlaufenden Signalleitung (24), wobei eine Massefläche (34) in einer zweiten Lage (16) der Leiterkarte (10) angeordnet ist, **dadurch gekennzeichnet, daß** die zu filternde Signalleitung (24) in der ersten Lage (14) im Filterbereich (12) unterbrochen ist und in einer dritten Lage (18) weitergeführt wird, wobei sich die zweite und dritte Lage (16 bzw. 18) auf gegenüberliegenden Seiten der ersten Lage (14) befinden.

2. Leiterkarte nach Anspruch 1, **dadurch gekennzeichnet, daß** die zweite und/oder die dritte Lage (16 bzw. 18) eine zu der ersten Lage (14) benachbarte Lage ist.

3. Leiterkarte nach Anspruch 1 oder 2, **dadurch gekennzeichnet, daß** die zu filternde Signalleitung (24) hinter dem Filterbereich (12) wieder in der ersten Lage (14) weitergeführt wird, wobei die zu filternde Signalleitung (24) in der ersten Lage (14) einen ersten und einen zweiten voneinander getrennten Abschnitt (26 bzw. 28) sowie einen dritten Abschnitt (36;48) in der dritten Lage (18) definiert.

4. Leiterkarte nach einem der Ansprüche 1-3, **dadurch gekennzeichnet, daß** die zu filternde Signalleitung (24) eine oder mehrere Kondensatorflächen (30,32) in dem Filterbereich (12) aufweist.

5. Leiterkarte nach Anspruch 3 oder 4, **dadurch gekennzeichnet, daß** der dritte Abschnitt (36;48) der Signalleitung (24) Induktivitäten (48), Kapazitäten und/oder ohmsche Widerstände enthält.

6. Leiterkarte nach einem der Ansprüche 1-5, **dadurch gekennzeichnet, daß** die Filteranordnung mit einer zusätzlichen L- und/oder C-Filterung (52,54) kombiniert wird.

7. Leiterkarte nach einem der Ansprüche 1-6, **gekennzeichnet durch** ein mit einer HF-Schirmwand versehenes Gehäuse, in welchem die Leiterkarte (10) angeordnet ist.

## Claims

1. Multilayer printed circuit card (10) having a filter arrangement for separating RF energy and signal energy in a signal line (24) which runs at least partially in a first layer (14) of the multilayer printed circuit card (10), an earth area (34) being arranged in a second layer (16) of the printed circuit card (10), **characterized in that** the signal line (24) to be filtered is interrupted in the first layer (14) in the filter region (12) and is continued in a third layer (18), the second and third layers (16 and 18) being situated on opposite sides of the first layer (14).

2. Printed circuit card according to Claim 1, **characterized in that** the second and/or the third layer (16 and/or 18) is/are a layer (layers) that is (are) adjacent to the first layer (14).

3. Printed circuit card according to Claim 1 or 2, **characterized in that** the signal line (24) to be filtered is continued again in the first layer (14) after the filter region (12), the signal line (24) to be filtered defining a first section (26) and a second section (28), which are separate from one another, in the first layer (14) and defining a third section (36; 48) in the third layer (18).

4. Printed circuit card according to one of Claims 1-3, **characterized in that** the signal line (24) to be filtered has one or more capacitor areas (30, 32) in the filter region (12).

5. Printed circuit card according to Claim 3 or 4, **characterized in that** the third section (36; 48) of the signal line (24) contains inductances (48), capacitances and/or non-reactive resistances.

6. Printed circuit card according to one of Claims 1-5, **characterized in that** the filter arrangement is combined with additional L and/or C filtering (52, 54).

7. Printed circuit card according to one of Claims 1-6, **characterized by** a housing which is provided with an RF screen wall and in which the printed circuit card (10) is arranged.

## Revendications

1. Plaquette de circuits imprimés à plusieurs couches (10) avec un dispositif de filtrage pour la séparation d'énergie à haute fréquence et d'énergie de signal dans un conducteur de signal (24) situé au moins en partie dans une première couche (14) de la plaquette de circuits imprimés à plusieurs couches (10), dans laquelle une surface de masse (34) est disposée dans une deuxième couche (16) de la plaquette de circuits imprimés (10), **caractérisée en ce que** le conducteur de signal à filtrer (24) est interrompu dans la zone de filtrage (12) dans la première couche (14) et est poursuivi dans une troisième couche (18), dans laquelle la deuxième couche et la troisième couche (16 respectivement 18) se trouvent sur des faces opposées de la première couche (14).

2. Plaquette de circuits imprimés selon la revendication 1, **caractérisée en ce que** la deuxième couche et/ou la troisième couche (16 respectivement 18) est/sont une couche adjacente à la première couche (14).

3. Plaquette de circuits imprimés selon la revendication 1 ou 2, **caractérisée en ce que** le conducteur de signal à filtrer (24) est de nouveau poursuivi dans la première couche (14) derrière la zone de filtrage (12), le conducteur de signal à filtrer (24) définissant un premier segment et un deuxième segment (26 respectivement 28) séparés l'un de l'autre dans la première couche (14) ainsi qu'un troisième segment (36; 48) dans la troisième couche (18).

4. Plaquette de circuits imprimés selon l'une quelconque des revendications 1 à 3, **caractérisée en ce que** le conducteur de signal à filtrer (24) présente une ou plusieurs surfaces de condensateur (30, 32) dans la zone de filtrage (12).

5. Plaquette de circuits imprimés selon la revendication 3 ou 4, **caractérisée en ce que** le troisième segment (36; 48) du conducteur de signal (24) contient des inductances (48), des condensateurs et/ou des résistances ohmiques.

6. Plaquette de circuits imprimés selon l'une quelconque des revendications 1 à 5, **caractérisée en ce que** le dispositif de filtrage est combiné avec un filtrage L et/ou C supplémentaire (52, 54).

7. Plaquette de circuits imprimés selon l'une quelconque des revendications 1 à 6, **caractérisée par** un boîtier pourvu d'un blindage HF, dans lequel la plaquette de circuits imprimés (10) est placée.
